Europäisches Patentamt

European Patent Office

Office européen des brevets

(11) Veröffentlichungsnummer: **0 336 072**
**A2**

## (12) EUROPÄISCHE PATENTANMELDUNG

(21) Anmeldenummer: 89102279.0

(22) Anmeldetag: 10.02.89

(51) Int. Cl.4: **B32B 27/38** , **B32B 27/04**

(30) Priorität: 04.03.88 DE 3807617
04.03.88 DE 3807618

(43) Veröffentlichungstag der Anmeldung:
**11.10.89 Patentblatt 89/41**

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Bressel, Burkhard, Dr.**
**Kuno-Fischer-Strasse 13**
**D-1000 Berlin 19(DE)**
Erfinder: **Grapentin, Hans-Joachim**
**Wundtstrasse 17**
**D-1000 Berlin 19(DE)**
Erfinder: **Möpert, Christiane**
**Presselstrasse 12**
**D-1000 Berlin 41(DE)**
Erfinder: **Riedl, Andrea**
**Hallesches Ufer 28**
**D-1000 Berlin 61(DE)**

(54) **Basismaterial aus Epoxid-Harz.**

(57) Die Erfindung betrifft ein Basismaterial aus Epoxid-Harz, vorzugsweise in Form von Platten, welches gegebenenfalls mehrschichtig aufgebaut ist und jeweils als Innenschicht Füllstoffe, insbesondere eine oder mehrere mit Epoxid-Harz getränkte Glasfasermatten oder mit Epoxid-Harz imprägniertes Papier, und als Außenschicht eine Epoxidharzschicht aufweist, dadurch gekennzeichnet, daß das Basismaterial einen Erweichungs (Tg)-Punkt oberhalb $130°$ C besitzt und/oder, daß die Außenschicht eine Dicke von mindestens $10$ $\mu$m besitzt.

EP 0 336 072 A2

Xerox Copy Centre

## BASISMATERIAL AUS EPOXID-HARZ

Die Erfindung betrifft ein neues Basismaterial aus Epoxid-Harz, vorzugsweise in Form von Platten, welches mehrschichtig aufgebaut ist und jeweils als Innenschicht Füllstoffe, insbesondere eine oder mehrere mit Epoxid-Harz getränkte Glasfasermatten oder mit Epoxid-Harz imprägniertes Papier, und als Aussenschicht eine Epoxid-Harzschicht aufweist.

Leiterplatten werden vorzugsweise nach der Substraktivtechnik hergestellt. Hierbei kommen als Grundmaterial beidseitig dünner Kupferauflage versehene Epoxidharzplatten zum Einsatz, die häufig durch Glasfasernetzwerke verstärkt sind, in vielen Fällern jedoch Phenolharzpapier im Innern tragen. Die Herstellung von Leiterplatten nach diesem Verfahren beinhaltet im wesentlichen die Metallisierung der für die Aufnahme von Bauteil-Anschlußstiften oder für die elektrische Verbindung verschiedener Verdrahtungsebenen dienenden Bohrlöcher und der damit verbundenenen Arbeitsschritte Bohrlochreinigung, -konditionierung, -aktivierung und -metallisierung.

Ein wesentlicher Nachteil des genannten Verfahrens besteht darin, daß die erforderlichen Ätzprozesse zur Herstellung der auf den Außenflächen der Leiterplatte liegenden Leiterbahnstrukturen einerseits unwirtschaftlich sind, da das in Lösung gehende Kupfer entsorgt und wieder zurückgewonnen werden muß und andererseits wesentliche Restriktionen an die Feinheit der auf den Außenflächen der Leiterplatte erzeugten Leiterbahnstrukturen (Breite und Abstand der Leiterbahnen) darstellen. Dieser zweite Punkt ist durch die nicht unerhebliche Unterätzung der Leiterzüge zu erklären, da die vollständige Dicke der auf das Grundmaterial auflamierten kupferfolie abgetragen werden muß. Aus technologischen Gründen ist eine Untergrenze der Kupferfoliendicke von 17 m nicht zu unterschreiten. Dünnere Kupferfolien haben sich in der Praxis nicht durchsetzen können, da derartig beschichtete Epoxidharz-Grundmaterialien nur schwierig herstellbar und damit teuer sind.

Darüber hinaus werden sehr hohe Anforderungen an die Konstanz des Ätzprozesses gestellt, wenn dickere Kupferschichten abgetragen werden müssen. Um diese Einschränkungen zu umgehen, kann man sich der Additiv- oder der Semiadditivtechnik bedienen, bei denen von der nicht mit Kupfer beschichteten Epoxidharzplatte ausgegangen wird. Deratige Techniken, deren Beherrschung der ordnungsgemäßen Bohrlochmmetallisierung auch von der haftfesten Metallisierung auf den Außenflächen der Leiterplatte abhängt, werden in geringem Umfang mit solchen Grundmaterialien angewandt, die für die erwähnte ausreichende Haftung einen Kleberfilm tragen.

Ein erheblicher Nachteil dieser Materialien, der die Verbreitung der erwähnten Leiterplattenherstelltechniken stark behindert hat, besteht in der Verwendung einer Kleberschicht.

Zum einen sind derartige mit Kleberschichten versehenen Basismaterialien teuer. An die Kleberschicht werden erhebliche Qualitätsanforderungen in Bezug auf die Konstanz der Klebereigenschaften sowohl von Platte zu Platte als auch im mikroskopischen Bereich gestellt. Darüber hinaus hat sich eine erhebliche mechanische Empfindlichkeit der Kleberschicht herausgestellt, die leicht zu Beschädigungen der Basismaterialoberfläche führen. Die Haftung des Kleberfilms auf dem Epoxidharz-Grundmaterial wird häufig beanstandet, so daß ein ordnungsgemäßer Zusammenhalt des Gesamtverbundes Grundmaterial/Kleber/Kupfer nicht in allen Fällen gewährleistet ist.

Diese Nachteile können dadurch umgangen werden, daß eine direkte Metallisierung nach geeigneter Vorbehandlung des Epoxidharzmaterials vorgenommen wird. Derartige Verfahren, die zum Beispiel einen oxidativen Aufschluß in einer $Cr(-VI)$- oder Permanganat-Ionen enthaltenen Lösung nach einem Quellschritt in einem organischen Lösungsmittel voraussetzen, sind an sich bekannt. Erfolgt im Anschluß an den oxidativen Angriff der Harzoberfläche eine Vorbehandlungs-/Bekei mungs-/Metallisierungssequenz nach herkömmlichem Muster, so werden festhaftende Metallschichten erhalten, die auch einer thermischen Belastung (zum Beispiel Eintauchen des metallisierten Substrates in ein Lötbad von 288° C für 10 sec) ohne Schaden überstehen.

Die genannte Technik konnte sich jedoch nicht durchsetzen, da durch den oxidativen Angriff, der eine Aufrauhung des Epoxidharzmaterials nach sind zieht, Glasfasern des Verbundmaterials teilweise freigelegt werden. Dies führt in der Leiterplattenherstellung zu zwei nachteiligen Effekten, die so schwerwiegend sind, daß das Verfahren in dieser Weise nicht angewandt werden kann: Zum einen ist die Haftung des Kupfers auf den Glasfasern außerordentlich gering, so daß lokale Defekte auftreten, die insbesondere bei sehr schmalen Leiterzügen schwerwiegende Folgen nach sich ziehen. Zum anderen können hervorstehende Glasfasern infolge der entstehenden Unebenheit Probleme bei der Übertragung des Leiterbildes bei den bildgebenden Techniken ergeben.

Aufgabe der vorliegenden Erfindung ist die Schaffung eines Basismaterials, das ohne Freilegung von Füllstoffen, insbesondere Glasfasern, zum Zwecke einer nachfolgenden Metallisierung geätzt beziehungsweise aufgerauht werden kann.

Diese Aufgabe wird erfindungsgemäß gelöst durch ein Basismaterial gemäß dem kennzeichnenden Teil des Patentanspruchs.

Weitere Ausgestaltungen sind dem Kennzeichnungteil des Unteranspruchs zu entnehmen.

Gegenstand der Erfindung ist weiterhin die Verwendung dieses Basismaterials zur Herstellung von Leiterplatten und ein Verfahren zur Herstellung dieser Leiterplatten.

Das einen Erweichungs (Tg)-Punkt oberhalb 130° C aufweisende Basismaterial hat den außerordentlichen Vorteil, bei einer Vorbenhandlungssequenz in der angegebenen Weise der direkten Metallisierung von Epoxid-Harz Oberflächen keine Füllstoffe beziehungsweise Glasfaserfragmente freizulegen.

Ein weiterer Vorteil besteht darin, daß die derart erhaltenen Metallschichten eine überraschend hohe Haftfestigkeit aufweisen.

Die erfindungsgemäß für das neue Basismaterial einzusetzenden Ausgangsmaterialien, das sind hochvernetzte Harze, tetrafunktionelle Harze oder Novolackkomponenten, sin an sich bekannt oder können nach an sich bekannten Verfahren hergestellt werden.

Das in der Aussenschicht mit einer Dicke von mindestens 10 m besonders harzreiche Basismaterial hat den weiteren Vorteil, bei einer Vorbehandlungssequenz in der angegebenen Weise der direkten Metallisierung von Epoxid-Harz Oberflächen keine Füllstoffe beziehungsweise Glasfaserfragmente freizulegen.

Derartiges harzreiches Basismaterial läßt sich zum Beispiel herstellen, indem beim Verpressen der mit Harz getränkten Glasfasermatten (sogenannte Prepregs) für die Außenlagen spezielle Schichten verwendet werden. Diese werden beispielsweise durch mehrmaliges Tränken der Glasfasermatten in dem noch flüssigen Epoxidharz präpariert, indem nach dem ersten Imprägnierschritt eine Trocknung vorgenommen wird, um im zweiten Imprägnierschritt eine weitere Harzschicht im erfindungsgemäßen Sinne aufzubringen. Die weiteren Verarbeitungsschritte erfolgen in der üblichen Weise.

Eine Anwendungsmöglichkeit für die erfindungsgemäßen Materialien besteht darin, zur Herstellung komplexer Mehrlagenschaltungen die Leiterzugsstrukturen auf den innen liegenden Ebenen in der erwähnten Weise der direkten Metallisierung von dünneren Laminaten zu erzeugen und diese Glasfaser/Epoxidharz/Kupfer-Folien nach der Strukturierung in der üblichen Weise weiterzuverarbeiten. Dieses Verfahren bietet gegenüber üblichen Verfahren der Kupfer-Kaschierung von Prepregs mit anschließender Strukturierung durch Ätzung die erwähnten Vorteile. Darüber hinaus kann im Falle der Anwendung der Additivtechnik eine planare Struktur erhalten werden, bestehend aus Kupferleiterzügen und dem auf dem Laminat verbleibenden Photoresists.

Diese Technik wird dort angewandt, wo es auf höchste Güte der Schaltung im - Hochfrequenzbereich ankommt, da die Impedanz der erzeugten Leiterzüge in kontrollierten engen Grenzen gehalten werden kann.

Weitere Anwendungsbereiche des erfindungsgemäßen Basismaterial betreffen unter anderem die Herstellung faserverstärker (Glas-, Kohle-, Aramid-, Teflonfasern) Formkörper in der Elektrotechnik oder in anderen Bereichen, wo vor der erforderlichen Metallisierung eine dünne Schicht eines Epoxidharzlackes aufzutragen ist, deren Dikke die der beim oxidativen Angriff erfolgenden Aufrauhung übersteigt. Eine gleichmäßige Beschichtung der Formkörper kann zum Beispiel durch elektrophoretische Verfahren erfolgen. Auch mit Mineralien gefüllte Formkörper können in dieser Weise von Epoxidharzschichten harzeich umschlossen werden.

Vor der Metallisierung der bereits verpressten Mehrlagenschaltung oder versteckte Durchkontaktierungen tragende Innenlagenpakete werden vorzugsweise die für die Aufnahme von Bauteil-Anschlußstiften oder die für die Durchkontaktierungen vorgesehenen Bohrungen angebracht, die dann zusammen mit den Außenflächen vorbehandelt, bekeimt und metallisiert werden.

Die Metallisierung des erfindungsgemäßen Basismaterials erfolgt in der an sich bekannten Weise.

Die Oberfläche wird zunächst in einem organischen Quellmittel, wie zum Beispiel Dimethylsulfoxid, 1-Methyl-2-pyrrolidon, Dimethylformamid, Dimethylacetamid, Dimethylacetal oder in Gemischen dieser Lösungsmittel untereinander und/oder mit Wasser behandelt. Diese Behandlungslösung kann zusätzlich zur Intensivierung des Angriffs ein oder mehrere Netzmittel enthalten und je nach Flüchtigkeit des Lösungsmittels bei erhöhten Temperaturen oder bei Raumtemperatur betrieben werden.

Nach einer Zwischenspülung erfolgt der oxidative Angriff mit einem Ätzmittel, wie in an sich bekannter Weise mit Chromsäure, Chromsäure enthaltenden Mischungen oder Permanganat-Lösungen, die ebenfalls netzmittelhaltig sein können bei Temperaturen zwischen Raumtemperatur und 90° C, vorzugswweise bei 70° C.

Anschließend erfolgt nach einem weiteren Spülschritt eine Entfernung von Resten des Atzmediums, zum Beispiel durch einen Neutralisationsschritt beziehungsweise eine Reduktionsreaktion. Die sich anschließenden Prozeßstufen können sich zum Beispiel aus den aus der Bohrlochmetallisierung bekannten Stufen Konditionieren, Atzreinigen, Bekeimen, Metallisieren ableiten.

Sollen metallische Strukturen auf dem Substrat erzeugt werden, so kann eines der in der Leiterplattentechnik angewandten Verfahren herangezogen werden.

Wird das Additiv-Verfahren bevorzugt, so wird nach der oben beschriebenen Vorbehandlung der Oberfläche und der Aktivierung mit Hilfe eines bildgebenden Verfahrens eine positive Reproduktion der gewünschten Metallstruktur in Form von Kanälen erzeugt. Anschließend erfolgt die Metallisierung in an sich bekannter Weise mit einem autokatalytisch arbeitenden Metallabscheidungsbad, vorzugsweise einem Kupfer- oder Nickelbad.

Selbstverständlich kann die bildgebende Prozeßstufe auch innerhalb der Vorbehandlungssequenz von der Bekeimung der Oberfläche erfolgen, sofern dafür Sorge getragen wird, daß eine Metallisierung des Galvanoresists nich erfolgt.

Im Falle der Semiadditivtechnik erfolgt nach der Vorbehandlung und der Aktivierung der Oberfläche eine ganzflächige Metallisierung mit Hilfe eines autokatalytisch arbeitenden Metallabscheidungsbades, vorzugsweise einem Kupfer- oder Nickelbad. Anschließend kann noch eine dünne Metallschicht aus einem elektrolytisch abscheidenden Metallbad, vorzugsweise einem Kupferbad, aufgebracht werden. Die Gesamtschichtdicke beträgt beispielsweise 3-5 m. In jedem Falle erfolgt dann eine bildgebende Prozeßstufe in bekannter Weise. Anschließend werden die im späteren Leiterbild erwünschten Metallstrukturen auf elektrolytischem Wege auf die erforderliche Endschichtdicke, zum Beispiel 35 m verstärkt. Nach dem Entfernen des Galvanoresists werden alle nicht verstärkten Partien durch eine Differenzätzung entfernt. Alternativ kann zuvor ein Ätzresist aufgebracht werden. Zum Einsatz kommen zum Beispiel Zinn/Blei-, Zinn-, Blei-, Nickel, Gold, Palladium/Nickel-Schichten beziehungsweise deren Schichtkombinationen zum Einsatz. Bei der Herstellung der Innenlagen wird als Endschicht anstatt der erwähnten Ätzresiste die freiliegenden Kupferschicht zu Kupferoxid oxidiert, um Schwarz- oder Braunoxid zu ergeben. Alternativ kann auch stromlos verzinnt werden.

Das folgende Beispiel dient zur Erläuterung der Erfindung.

## BEISPIEL 1

Eine Mehrlagenschaltung, die aus tetrafunktionellem Epoxidharz in bekannter Weise hergestellt wird, wird nach folgendem Prozeßablauf metallisiert:

    1. Quellen in einer Dimethylformamidlösung bei erhöhter Temperatur (50° C),
    2. Spülen,

    3. Ätzen in einer Chromsäurelösung (500 g/l) bei erhöhter Temperatur (70° C),
    4. Spülen,
    5. Reduzieren anhaftender Chromsäurereste in einer natriumbisulfitlösung,
    6. Spülen.

Die weiteren Schritte erfolgen in Bekannter Weise analog zur Bohrlochmetallisierung, nämlich Konditionierung, Bekeimung, autokatalytische und galvanische Kupferabscheidung. Man erhält eine festhaftende Kupferschicht ohne Blasen.

## BEISPIEL 2

Zur Herstellugn eines für die direkte Metallisierung der Außenfläche einer Leiterplatte geeigneten Substrats werden Glasfasermatten in einer hierfür üblichen Epoxidharzlösung, die mit den entsprechenden Mengen an Beschleuniger und Härter versetzt ist, imprägniert, getrocknet, erneut imprägniert und getrocknet. Diese werden zusammen mit den in üblicher Weise hergestellten imprägnierten Glasfasermatten so verpreßt, daß die doppelt imprägnierten Folien außen liegen. Man erhält nach Aushärtung ein harzreiches Laminat. Dieses wird anschließend nach folgenden Schritten metallisiert.

    1. Quellen in einer Dimethylformamidlösung bei erhöhter Temperatur (50° C),
    2. Spülen,
    3. Ätzen in einer Chromsäurelösung (500 g/Liter bei erhöhter Temperatur (70° C)
    4. Spülen,
    5. Reduzieren anhaftender Chromsäurereste in einer Natriumbisulfitlösung,
    6. Spülen,

Die weiteren Schritte erfolgen in bekannter Weise analog zur Bohrlochmetallisierung, nämlich Konditionierung, Bekeimung, autokatalytische und galvanische Kupferabscheidung. Man erhält eine festhaftende Kupferschicht ohne Blasen.

## Ansprüche

1. Basismaterial aus Epoxid-Harz, vorzugsweise in Form von Platten, welches gegebenenfalls mehrschichtig aufgebaut ist und jeweils als innenschicht Füllstoffe, insbesondere eine oder mehrere mit Epoxid-Harz getränke Glasfasermatten oder mit Epoxid-Harz imprägniertes Papier, und als Außenschicht eine Epoxid-Harzschicht aufweist, dadurch gekennzeichnet, daß das Basismaterial einen Erweichungs (Tg)-Punkt oberhalb 130° C besitzt und/oder, daß die Außenschicht eine Dicke von mindestens 10 $\mu$m besitzt.

2. Basismaterial gemäß Anspruch 1, dadurch gekennzeichnet, daß das Basismaterial einen Erweichungs (Tg)-Punkt oberhalb 130° C besitzt.

3. Basismaterial gemäß Anspruch 1, dadurch gekennzeichnet, daß die Außenschicht eine Dicke von mindestens 10 μm besitzt.

4. Basismaterial gemäß Anspruch 2, dadurch gekennzeichnet, daß dieses ein hochvernetztes Harz darstellt.

5. Basismaterial gemäß Anspruch 2, dadurch gekennzeichnet, daß dieses ein tetrafunktionelles Epoxidharz darstellt.

6. Basismaterial gemäß Anspruch 1, dadurch gekennzeichnet, daß dieses Beschleunigungs- und Härtemittel enthält.

7. Verwendung von Basismaterial gemäß Anspruch 1 zur Herstellung von Leiterplatten.

8. Verfahren zur Herstellung von Leiterplatten, dadurch gekennzeichnet, daß Basismaterial gemäß Anspruch 1, zunächst mit einem organischen Quellmittel vorbehandelt wird, dann nach Einwirkung eines Ätzmittels aktiviert und anschließend chemisch und gegebenenfalls galvanisch metallisiert wird.

9. Verfahren gemäß Anspruch 8, dadurch gekennzeichnet, daß zur Herstellung der metallisierten und strukturierten Flächen die Semi-Additiv-Technik oder die Additiv-Technik eingesetzt wird.